# EUROPEAN PATENT SPECIFICATION

(11) **EP 2 145 336 B1**
(45) Date of publication and mention of the grant of the patent: **09.11.2011**
(21) Application number: 08753432.7
(22) Date of filing: 09.05.2008
(51) Int. Cl.: G12B 17/02

(54) **EMI SHIELD GLASS WITH BLACKENED CONDUCTIVE PATTERN AND A METHOD FOR PREPARATION THEREOF**
EMI-ABSCHIRMUNGSGLAS MIT GESCHWÄRZTER LEITFÄHIGER STRUKTUR UND VERFAHREN ZU IHRER HERSTELLUNG
VERRE NOIRCI BLINDÉ CONTRE LES INTERFÉRENCES ÉLECTROMAGNÉTIQUES, ET SA MÉTHODE DE PRODUCTION

(30) Priority: 10.05.2007 KR 20070045278
(43) Date of publication of application: 20.01.2010
(73) Proprietor: LG Chem, Ltd., Youngdungpo-gu, Seoul 150-721 (KR)
(72) Inventor: CHUN, Sang-Ki, Daejeon 305-380 (KR); HWANG, In-Seok, Daejeon Metropolitan City 305-340 (KR); LEE, Dong-Wook, Daejeon Metropolitan City 305-729 (KR); KIM, Seung-Wook, Yuseong-gu Daejeon, 305-380 (KR)
(74) Representative: Goddar, Heinz J.
(86) International application number: PCT/KR2008/002636
(87) International publication number: WO 2008/140234

(56) References cited:
- JP-A- 2002 057 490
- JP-A- 2002 271 086
- US-A- 5 017 419
- US-A- 6 030 708
- US-A1- 2003 013 048
- US-A1- 2006 163 197

## Description

### Technical Field

The present invention relates to a method of producing an electromagnetic interference shielding glass that is blackened while low specific resistance is maintained in order to sufficiently show an electromagnetic interference shielding function of a conductive pattern so as not to affect contrast of a display device, and an electromagnetic interference shielding glass that is produced by using the same.

This application claims priority from Korean Patent Application No. 2007-0045278 filed on May 10, 2007 in the Korean Intellectual Property Office.

### Background Art

In the related art, in order to shield the harmful electromagnetic wave from the PDP (Plasma Display Panel), a mesh pattern that is made of a copper material is manufactured by using a photolithography process.

However, since the photolithography process is complicated and the cost of the raw material is high, the production cost is high and is most costly in respect to raw material of the PDP filter.

However, since the competition of PDPs and LCDs (Liquid Crystal Display) is becoming seriously deepened in FPD (Flat Panel Display) market, it is necessary to develop a low-priced raw material, and a technology has been developed to print a conductive paste by using a mesh pattern according to a printing process such as screen printing process, an offset printing process or the like.

It is necessary to sufficiently reduce the specific resistance of the conductive paste that is used to perform the printing so that the characteristics of the electromagnetic interference shielding film produced by using the printing process are sufficiently realized.

In order to achieve this, the use of the conductive paste including the metal powder has been developed. However, in case the conductive pattern is printed by using conductive paste according to the offset printing process, light and external light is reflected from the PDP due to a gloss of metal, which negatively affects contrast.
US 2006/0163197 A1 describes an electromagnetic shielding sheet and a blacking treatment for forming a black coating layer on the surface thereof. The blacking treatment may include depositing a metal, an alloy, a metal oxide or a metal sulfide or applying a resin containing a black coloring matter.
JP 2002 057490 A having a print pattern on the surface thereof obtained by printing a conductive ink composition containing conductive powder.
JP 2002 271086 A describes an electromagnetic wave shield plate comprising a glass substrate and a conductive geometric pattern formed thereon which may, if desired, contain a black pigment.
US 5017419 A describes a shielded substrate having a randomly orientate, non-linear conductive pattern formed thereon through the use of photolithography process.
US 6030708 A describes a transparent shielding material for a electromagnetic interference in which a black mesh region is formed in a hydrophilic transparent resin layer on a transparent substrate wherein the hydrophilic transparent resin layer, in certain areas contains metal particles fmally dispersed therein to form black regions.
US 2003/0013048 A1 describes an electromagnetic filter for a display screen with a conductive pattern on transparent surface obtained by placing a thick film photo-printable composition on a substrate, exposing the thick film to a photo mask having a desired grid pattern and firing the developed composition to make the material conductive.
Therefore, there is a need to perform the blackening treatment of the conductive pattern.

### Disclosure of Invention

### Technical Problem

Therefore, it is an object of the present invention to provide a method of manufacturing an electromagnetic interference shielding glass in which a film type of electromagnetic interference shielding part is not formed but an electromagnetic interference shielding part is directly formed on a surface of the glass to simplify a structure and a manufacturing process, an optimum conductivity is ensured because a firing temperature is freely controlled to sufficiently perform the firing, and the conductive pattern formed on the glass is simply blackened, and a blackened electromagnetic interference shielding glass that is manufactured by using the same.

In particular, the present invention provides a method of manufacturing an electromagnetic interference shielding glass in which through the firing step for the fixing of the conductive pattern, a separate blackening treatment step is not performed and an interface between the conductive pattern and the glass is blackened without an increment of surface resistance, and a blackened electromagnetic interference shielding glass that is manufactured by using the same.

In addition, the present invention provides a PDP filter that includes a blackened electromagnetic interference shielding glass according to the present invention; and an anti-reflection film, a near infrared ray shielding film, or a color correction film additionally attached to the blackened electromagnetic interference shielding glass, and a PDP device that includes the same.

### Technical Solution

The present invention provides a method of producing a blackened electromagnetic interference shielding glass, which includes (a) forming a conductive pattern with a conductive paste on a surface of glass on which a tin (Sn) component is diffused; and (b) firing the glass on which the conductive pattern is formed.

The present invention provides a blackened electromagnetic interference shielding glass that includes a glass on which a tin component is diffused at least at a surface thereof; and a conductive pattern that is formed on the surface of the glass on which the tin component is diffused, wherein an interface between the conductive pattern and the glass is blackened by firing the glass on which the conductive pattern is formed.

The present invention provides a PDP filter that includes a blackened electromagnetic interference shielding glass according to the present invention; and at least one film that is attached to a front side or a rear side of the blackened electromagnetic interference shielding glass and is selected from the group consisting of an anti-reflection film, a near infrared ray shielding film, and a color correction film.

The present invention provides a PDP device comprising the PDP filter according to the present invention.

### Advantageous Effects

According to the present invention, it is provided with a method of producing an electromagnetic interference shielding glass and an electromagnetic interference shielding glass that is produced by using the same, in which an interface between a conductive pattern and a glass substrate is blackened without an increment of surface resistance to avoid a problem of contrast caused by luster of metal.

In addition, since a blackening treatment process is performed during a firing process to fix a conductive pattern on the glass, a separate blackening process is unnecessary. Thus, through the production process of the electromagnetic interference shielding glass and the simplification of the device, an improvement in the productivity can be achieved.

### Best Mode for Carrying Out the Invention

A method of producing a blackened electromagnetic interference shielding glass according to the present invention includes (a) forming a conductive pattern with a c onductive paste on a surface of glass on which a tin (Sn) component is diffused; and (b) firing the glass on which the conductive pattern is formed.

In step (a), the glass on which the tin component is diffused may be produced by using a typical float process in which molten glass is injected on an upper surface of molten tin having high specific gravity to produce flat glass having no concave and convex portions.

In particular, it is preferable that the conductive pattern be formed on the surface of the glass on which the tin component is diffused. In case the conductive pattern is formed on an opposite side, it is required that a separate blackening treatment process is performed.

In case tin is present on the surface of the glass, tin may be verified by its frosty appearance through the use of a halogen lamp, and if the cut side is observed, when tin is present, the side on which tin is present is smooth.

In the glass on which the tin component is diffused, tin of the glass is present in a Sn ²⁺ or Sn⁴⁺ ion state.

In the glass on which the tin component is diffused, the content of tin may be a few ppm, and preferably more than 0 and 1000 ppm or less, but is not limited thereto. Even though the amount of the tin component is small, since the surface reaction shows colors, the sufficient operation effect may be shown.

The composition and the thickness of the glass are not limited if the tin component is diffused on at least one surface in the glass, but the thickness is preferably in the range of 0.5 to 5 mm.

The type of conductive paste is not limited, but the conductive paste may include one or more metal powders selected from the group consisting of copper, silver, gold, and aluminun, an organic binder resin solution in which a polymer binder is dissolved in an organic solvent, and a glass frit that is used to improve an adhesion strength between a conductive paste and a glass.

It is preferable to use the conductive paste that includes a silver (Ag) powder having excellent electric conductivity and low specific resistance as a metal powder. In the conductive paste that includes a silver (Ag) powder, before the firing, the silver (Ag) component is present in a particle state of bulk silver. After the firing is finished, while an organic substance that is included in the conductive paste is removed and silver (Ag) remains, the blackening is performed.

It is preferable that the conductive paste include 70 to 90% by weight of metal powder, 0.1 to 15% by weight of glass frit, and 5 to 30% by weight of organic binder resin solution that includes the polymer binder and the organic solvent.

In the organic binder resin solution, it is preferable for the content of the polymer binder to be 20 to 80 % by weight of the sun total of the weights of the organic solvent and the polymer binder.

For example, the conductive paste may be prepared by adding the colored glass flit, and the metal powder after the polymer binder is dissolved in the organic solvent to prepare the organic binder resin solution, kneading them, and uniformly dispersing the agglomerated metal powder and glass frit by using a three-stage roll mill.

It is preferable for the organic solvent to be selected from the group consisting of butyl carbitol acetate, carbitol acetate, cyclohexanone, cellosolve acetate, terpineol, and diethylene glycol monobutyl ether.

The polymer binder functions to maintain the shape of the conductive pattern when the conductive pattern is formed by using the conductive paste, and any one selected from a cellulose resin, an acryl resin, and a vinyl resin may be used.

In case the conductive pattern is formed by using the conductive paste including the metal powder, light or external light is reflected on the PDP module due to a gloss of metal, which negatively affects the contrast. Thus, in order to avoid this, it is required to perform the blackening treatment process.

A printing process in which carbon black or the black dye is added to the conductive paste to make the paste black may be performed. However, the specific resistance of the carbon black is high as compared to metal including silver and the like, and the black dye is non-conductive. Accordingly, the carbon black or the dye acts as an impurity in the conductive paste, thus causing an increase in surface resistance of the final product and problems in performance of the electromagnetic interference shielding.

Therefore, in order to avoid the above problems, in the present invention, the glass on which the tin component is diffused is used as a substrate for forming the conductive pattern and the firing of the conductive pattern and the glass is performed to finish the production of the blackened electromagnetic interference shielding glass without an increment of surface resistance. The specific description is as follows.

In case a glass plate is manufactured by using a typical float process, Sn²⁺ is diffused from molten tin to the glass.

According to the float process, molten glass is continuously supplied to molten tin at 600 to 1050°C, whch is contained in a float bath under a reduction atmosphere in which nitrogen is used as a main component, the glass is stretched, desorbed from molten tin, and cooled to produce the glass plate.

In this case, during the production on molten tin, tin (Sn⁰) is oxidized by oxygen that is present in a very small amount to permeate through the ion exchange reaction with Na⁺in the glass in a Sn²⁺ state, and has a much higher permeation rate as compared to Sn⁰ or Sn⁴⁺.

Sn²⁺ that starts to permeate may be converted into Sn⁴⁺ through the redox reaction with Fe³⁺ that is present in the glass (Journal of Non-Crystalline Solids, 2001, 282, 188).

Accordingly, on the surface, it is mainly present in a Sn²⁺ state, Sin⁰ or Sn⁴⁺ is present in a small amount. In connection with this, the diffusion depth of Sn²⁺ is 20 µm based on the glass surface that comes into contact with molten tin in the case of soda lime glass (J. Noncryst. Solids, 2000, 263, 133).

In case the conductive pattern is formed on the surface of glass on which Sn²⁺ is diffused by using the conductive paste and the high temperature firing is performed to fix the conductive pattern, Sn²⁺ that is diffused on the surface of glass is reacted with ions of metal powder in the conductive paste that is generated during the firing process For example, in the case of that silver (Ag) powder is used as the metal powder and the ion of the metal powder is Ag⁺, the reaction is perfomed according to the folowing Reaction Equation 1.

(Reaction Equation 1) Sn²⁺ + 2Ag⁺ → Sn⁴⁺ + 2Ag⁰ ; nAg⁰ ↔ (Ag⁰)ₙ

By the above reaction, Ag⁺ is reduced to Ag⁰ colloidal particles, and discolored to yellow brown colors. In connection with this, because of the diffusion of Ag⁺ by heat, a laterial side of the conductive pattern may be discolored, but the problems of the thermal diffusion may be minimized by appropriately controlling the processing temperature.

In the case of the conductive pattern that includes the silver (Ag) component, in order to minimize problems because of the thermal diffusion of Ag ⁺, the firing may be performed at 400 to 700°C and preferably 500 to 650°C.

In addition, in order to minimize the thermal diffusion problems, the firing time may be further controlled, and the firing may be performed at 500 to 650°C for 60 to 500 sec and preferably at 600 to 650°C for 120 to 300 sec.

This phenomenon is shown in the conductive paste that includes another metal powder. A representative example is a paste that includes a copper powder as a metal powder. Like silver, copper may be reacted with the tin component of molten tin according to the following Reaction Equation 2 and may have a ruby color.*

(Reaction Equation 2) Sn²⁺ + 2Cu⁺ → Sn⁴⁺ + 2Cu⁰ ; nCu⁰ ↔ (Cu⁰)ₙ

The rubi color is shown at about 450 nm by a free copper ion on a spectrum, and an absorption spectrum is shown at about 570 nm by (Cu⁰)ₙ nanocrystal (ref. J. Noncryst. Solids, 2006, 35, 534).

By the above-mentioned principle, an interface between the conductive pattern and the glass is made dark. Specifically, since silver nanoparticles, on the surface of which the tin component is present, is present at an interface between the conductive pattern and the glass, the reflectivity is reduced because of the metal component that is included in the conductive pattern, and since a material that colors the interface between the conductive pattern and the glass is the metal component, an increase in surface resistance does not occur.

In addition, the conductive pattern is formed on the glass on which the tin component is diffused by using the conductive paste that includes the colored glass frit, and then fired at a high temperature to blacken the interface between the conductive pattern and the glass substrate without an additional increment of surface resistance.

In case the conductive pattern is formed on an opposite side of the surface of the glass on which the tin component is diffused, the interface between the conductive pattern and the glass substrate may be blackened by using the colored glass frit.

The coloring component of the glass frit is not limited to the black color, and any color including an achromatic color such as gray color or brown color may be used as long as the color can cause the blackening effect while the color does not provide the sense of unwelcome to human.

Examples of the coloring component of the colored glass frit may include a manganese or coblat coloring component. For example, MnO and CoO may be used as the coloring component.

In the above step (a), the conductive pattern may be formed by using a printing process. A process of printing the conductive pattern on the surface of the glass may be selected from the group consisting of an offset printing process, a screen printing process, a gravure printing process, and an inkjet printing process, but is not limited thereto. Any printing process that is known in the art may be used as long as the printing can be directly performed on the surface of the glass.

In connection with this, the offset printing process includes filling a concave part of a flat plate or a roller that includes concave and convex parts with the conductive paste; bringing the flat plate or the roller into contact with a printed blanket to transfer the conductive paste from the concave part of the flat plate or the roller to the printed blanket; and bringing the printed blanket into contact with a surface of a glass to transfer the conductive paste from the printed blanket to the surface of the glass to form the electromagnetic interference shielding unit having the conductive pattern. In connection with this, the conductive paste may be transferred by using the convex part instead of the concave part.

In step (b), as described above, if the firing is performed at 400 to 700°C after the conductive pattern is formed on the surface of the glass, the glass frit that is included in the conductive paste is softened to improve adhesion strength between the conductive pattern and the glass.

In case the firing temperature is less than 400°C, metal powder that is included in the conductive paste, for example, the silver component may be dissolved to cause problems in melting of the glass. In addition, the firing temperature is less than 400°C, the glass frit is not desirably dissolved and the organic substance is not remved to reduce the adhesion strength between silver and the glass.

If the firing temperature is more than 700°C, since glass reformation such as distortion points that occurs because of the bending of the glass or the surface concave and convex portions may occur, it is difficult to apply for the purpose of displays.

Meanwhile, a blackened electromagnetic interference shielding glass according to the present invention includes

a glass on which a tin component is diffused at least at a surface thereof; and a conductive pattern that is formed on the surface of the glass on which the tin component is diffused. An interface between the conductive pattern and the glass is blackened by firing the glass on which the conductive pattern is formed. The above-mentioned contents according to the embodiments are all applied.

In the blackened electromagnetic interference shielding glass according to the present invention, the interface between the conductive pattern and the glass is blackened. This is formed by reaction of molten tin and metal that is included in the conductive pattern if glass on which the tin component is diffused into at least one side thereof and the conductive pattern is formed on that side is fired.

A PDP filter according to the present invention includes a blackened electromagnetic interference shielding glass; and at least one film that is attached to a front side or a rear side of the blackened electromagnetic interference shielding glass and is selected from the group consisting of an anti-reflection film, a near infrared ray shielding film, and a color correction film.

A PDP device according to the present invention includes a PDP filter; and a plasma display panel including the PDP filter.

The PDP filter may be provided at a front side of the plasma display panel that includes a pair of substrates.

### Mode for the Invention

A better understanding of the present invention may be obtained in light of the following Examples which are set forth to illustrate, but are not to be construed to limit the present invention.

EXAMPLE: Production of the blackened electromagnetic interference shielding glass

(1) Preparation of the conductive paste

Ethyl cellulose that was the polymer binder was dissolved in butyl carbitol acetate that was the organic solvent so that the content of ethyl cellulose that was the polymer binder in the organic binder resin solution was 40% by weight of the total weight of ethyl cellulose that was the polymer binder and butyl carbitol acetate that was the organic solvent to prepare an organic binder resin solution. The weight of the organic binder resin solution was 20% by weight based on the total weight of the paste.

The glass frit was added to the organic binder resin solution in an amount of 5% by weight based on the total weight of the conductive paste, the silver (Ag) powder was added as the metal powder to the organic binder resin solution in an amount of 75% by weight based on the total weight of the conductive paste, and kneading was performed.

Next, the agglomerated silver powder and glass frit were uniformly dispersed by using a three-stage roll mill, and it was confirmed that the paste dispersed by using the roll mill had the shape. Subsequently, the resulting paste was recovered.

(2) Printing and firing of the conductive pattern

The silver conductive paste that was prepared by using the above method was applied on the glass substrate that was formed by using the float process to form the conductive pattern by using the engraving offset printing process, fired at 600°C for 5 min, and cooled to normal temperature to produce the electromagnetic interference shielding glass having the blackened conductive pattern.

The glass was a soda lime glass that included 1 wt% or more Na₂O, and was produced by using the typical float process in which the molten glass was continuously supplied on molten tin at 600 to 1050°C that was contained in a float bath under a reduction atmosphere using nitrogen as the main component.

(3) Degrees of blackness and surface resistance detection

In respects to the products that were produced in Example, the surface resistance and the degrees of blackness were evaluated. In respects to the surface resistance, the surface resistance was obtained by using MCP-T600 manufactured by Mitsubishi Chemical, Co., Ltd., the degrees of blackness L was obtained by calculating the L value from the reflectivity after the reflectivity (550 nm) of the conductive pattern was measured by using UV-3600 manufactured by Shimadzu, Corp. The haze was measured by using HR-100, and the results are described in Table 1.

COMPARATIVE EXAMPLE: Production of the electromagnetic interference shielding glass not subjected to the blackening treatment

The conductive pattern was formed and the firing is performed by using the same conductive paste and printing method as the Example, except that the conductive pattern was formed on the opposite side of the surface of the glass on which the tin component is diffused, and the degrees of blackness and surface resistance were measured by using the same method as the Example.

The results are described in Table 1 in conjunction with the results of Example.

Table 1

### [Table 1]

**[Table]**

| | Example | Comparative Example |
|---|---|---|
| Surface resistance(Ω/) | 0.19 | 0.19 |
| Reflectivity (550 nm) | 6.2 | 8.6 |
| Degrees of blackness (L) | 25.0 | 29.2 |
| Haze | 0.4 | 1.1 |

As shown in Table 1, in the case of the electromagnetic interference shielding glass according to the present invention, the low reflectivity and the excellent degrees of blackness L was confirmed as compared to Comparative Example (the lower the degrees of blackness L was, the more black the glass was).

That is, when the electromagnetic interference shielding glass was produced as in the Comparative Example the surface resistance was the same as that of Example, because the conductive pattern was formed on the side of the glass, on which the tin component was not formed.

However, since there was no change in silver (Ag) component that was included in the conductive pattern, the reflectivity by the silver component was higher that of Example. That is, in the case of Comparative Example, since the blackening treatment by using the reaction of tin and the silver component was not performed, the reflectivity was higher than that of the Example.

As described above, by forming the conductive pattern on the surface of the glass on which the tin component is diffused, it can be seen that the electromagnetic interference shielding glass according to the present invention that is blackened by the reaction of tin of the glass and the metal of the conductive pattern has no an increment of surface resistance as compared to the Comparative Example, has low reflectivity because of the metal component that is included in the conductive pattern, and has excellent degrees of blackness.

## Claims

1. A method of producing a blackened electromagnetic interference shielding glass, the method comprising forming a conductive pattern with a conductive paste on a surface of glass,
**characterized in that**
a tin (Sn) component is diffused on said surface of glass; and the glass on which the conductive pattern is formed is fired.

2. The method of producing a blackened electromagnetic interference shielding glass as set forth in claim 1, wherein the glass on which the tin component is diffused is produced by using a float process.

3. The method of producing a blackened electromagnetic interference shielding glass as set forth in claim 1, wherein the conductive paste is prepared by dispersing metal powders, a polymer binder, and a glass frit in an organic solvent.

4. The method of producing a blackened electromagnetic interference shielding glass as set forth in claim 3, wherein the conductive paste comprises 70 to 90% by weight of metal powder, 0.1 to 15% by weight of glass frit, and 5 to 30% by weight of organic binder resin solution that comprises the polymer binder and the organic solvent, and the amount of the polymer binder in the organic binder resin solution is in the range of 20 to 80% by weight of the sum total of the weights of the organic solvent and the polymer binder.

5. The method of producing a blackened electromagnetic interference shielding glass as set forth in claim 3, wherein the glass frit comprises a colored glass frit.

6. The method of producing a blackened electromagnetic interference shielding glass as set forth in any one of claims 1 to 5, wherein the conductive pattern is formed by using the printing process.

7. The method of producing a blackened electromagnetic interference shielding glass as set forth in any one of claims 1 to 5, wherein the glass is fired at the temperature in the range of 400 to 700°C.

8. A blackened electromagnetic interference shielding glass comprising: a glass and a conductive pattern that is formed on a surface of the glass,
**characterized in that**, a tin component is diffused on said surface of the glass and an interface between the conductive pattern and the glass is blackened by firing the glass on which the conductive pattern is formed.

9. The blackened electromagnetic interference shielding glass as set forth in claim 8, wherein the conductive pattern is formed by using the conducive paste that is prepared by dispersing metal powders, a polymer binder, and a glass frit in an organic solvent.

10. The blackened electromagnetic interference shielding glass as set forth in claim 9, wherein the conductive paste comprises 70 to 90% by weight of metal powder, 0.1 to 15% by weight of glass frit, and 5 to 30% by weight of organic binder resin solution that comprises the polymer binder and the organic solvent, and the amount of the polymer binder in the organic binder resin solution is in the range of 20 to 80% by weight of the sum total of the weights of the organic solvent and the polymer binder.

11. The blackened electromagnetic interference shielding glass as set forth in claim 9, wherein the glass frit comprises a colored glass frit.

12. The blackened electromagnetic interference shielding glass as set forth in claim 8, wherein the conductive pattern is formed by using the printing process on the surface of the glass on which the thin component is diffused.

13. The blackened electromagnetic interference shielding glass as set forth in claim 8, wherein the blackened layer is formed by firing the glass on which the conductive pattern is formed at a temperature in the range of 400 to 700°C.

14. A PDP filter comprising:
a blackened electromagnetic interference shielding glass according to any one of claims 8 to 13; and
at least one film that is attached to a front side or a rear side of the blackened electromagnetic interference shielding glass and is selected from the group consisting of an anti-reflection film,
a near infrared ray shielding film, and a color correction film.

15. A PDP device comprising the PDP filter according to claim 14.

## Patentansprüche

1. Verfahren zur Herstellung eines geschwärzten Glases zur Abschirmung elektromagnetischer Interferenz, wobei das Verfahren die Ausbildung einer leitfähigen Struktur mit einer leitfähigen Paste auf einer Glasoberfläche umfasst, **dadurch gekennzeichnet, dass** eine Zinn(Sn)-Komponente auf der Glasoberfläche verteilt wird; und das Glas, auf dem die leitfähige Struktur ausgebildet ist, gebrannt wird.

2. Verfahren zur Herstellung eines geschwärzten Glases zur Abschirmung elektromagnetischer Interferenz nach Anspruch 1, wobei das Glas, auf dem die Zinn-Komponente verteilt wird, durch Verwendung eines Floatverfahrens hergestellt wird.

3. Verfahren zur Herstellung eines geschwärzten Glases zur Abschirmung elektromagnetischer Interferenz nach Anspruch 1, wobei die leitfähige Paste durch Dispergieren von Metallpulvern, einem Polymerbinder und einer Glasfritte in einem organischen Lösemittel hergestellt wird.

4. Verfahren zur Herstellung eines geschwärzten Glases zur Abschirmung elektromagnetischer Interferenz nach Anspruch 3, wobei die leitfähige Paste 70 bis 90 Gew.-% Metallpulver, 0,1 bis 15 Gew.-% Glasfritte und 5 bis 30 Gew.-% organische Binderharzlösung umfasst, die den Polymerbinder und das organische Lösemittel umfasst, und die Menge des Polymerbinders in der organischen Binderharzlösung im Bereich von 20 bis 80 Gew.-% der Gesamtsumme der Gewichte des organischen Lösemittels und des Polymerbinders liegt.

5. Verfahren zur Herstellung einer geschwärzten Glases zur Abschirmung elektromagnetischer Interferenz nach Anspruch 3, wobei die Glasfritte eine gefärbte Glasfritte umfasst.

6. Verfahren zur Herstellung eines geschwärzten Glases zur Abschirmung elektromagnetischer Interferenz nach einem der Ansprüche 1 bis 5, wobei die leitfähige Struktur durch Verwendung des Druckverfahrens ausgebildet wird.

7. Verfahren zur Herstellung eines geschwärzten Glases zur Abschirmung elektromagnetischer Interferenz nach einem der Ansprüche 1 bis 5, wobei das Glas bei der Temperatur im Bereich von 400 bis 700°C gebrannt wird.

8. Geschwärztes Glas zur Abschirmung elektromagnetischer Interferenz, das ein Glas und eine leitfähige Struktur, die auf einer Oberfläche des Glases ausgebildet ist, umfasst, **dadurch gekennzeichnet, dass** eine Zinn-Komponente auf der Oberfläche des Glases verteilt ist und eine Grenzfläche zwischen der leitfähigen Struktur und dem Glas durch Brennen des Glases, auf dem die leitfähige Struktur ausgebildet ist, geschwärzt ist.

9. Geschwärztes Glas zur Abschirmung elektromagnetischer Interferenz nach Anspruch 8, wobei die leitfähige Struktur durch Verwendung der leitfähigen Paste ausgebildet ist, die durch Dispergieren von Metallpulvern, einem Polymerbinder und einer Glasfritte in einem organischen Lösemittel hergestellt ist.

10. Geschwärztes Glas zur Abschirmung elektromagnetischer Interferenz nach Anspruch 9, wobei die leitfähige Paste 70 bis 90 Gew.-% Metallpulver, 0,1 bis 15 Gew.-% Glasfritte und 5 bis 30 Gew.-% organische Binderharzlösung umfasst, die den Polymerbinder und das organische Lösemittel umfasst, und die Menge des Polymerbinders in der organischen Binderharzlösung im Bereich von 20 bis 80 Gew.-% der Gesamtsumme der Gewichte des organischen Lösemittels und des Polymerbinders liegt.

11. Geschwärztes Glas zur Abschirmung elektromagnetischer Interferenz nach Anspruch 9, wobei die Glasfritte eine gefärbte Glasfritte umfasst.

12. Geschwärztes Glas zur Abschirmung elektromagnetischer Interferenz nach Anspruch 8, wobei die leitfähige Struktur durch Verwendung des Druckverfahrens auf der Oberfläche des Glases, auf dem die Zinn-Komponente verteilt ist, ausgebildet ist.

13. Geschwärztes Glas zur Abschirmung elektromagnetischer Interferenz nach Anspruch 8, wobei die geschwärzte Schicht durch Brennen des Glases, auf dem die leitfähige Struktur ausgebildet ist, bei einer Temperatur im Bereich von 400 bis 700°C ausgebildet ist.

14. PDP-Filter, umfassend:
ein geschwärztes Glas zur Abschirmung elektromagnetischer Interferenz nach einem der Ansprüche 8 bis 13; und
wenigstens einen Film, der an eine Vorderseite oder eine Rückseite des geschwärzten Glases zur Abschirmung elektromagnetischer Interferenz gebunden ist und ausgewählt ist aus der Gruppe, bestehend aus einem Antireflexionsfilm, einem Film zur Abschirmung von Strahlen aus dem nahen Infrarotbereich und einem Farbkorrekturfilm.

15. PDP-Vorrichtung, umfassend den PDP-Filter nach Anspruch 14.

## Revendications

1. Procédé de fabrication de verre noirci de blindage contre les interférences électromagnétiques, le procédé comportant la formation d'un réseau conducteur avec une pâte conductrice sur une surface de verre, **caractérisé en ce que** un composant d'étain (Sn) est diffusé sur ladite surface de verre ; et le verre sur lequel le réseau conducteur est formé est cuit.

2. Procédé de fabrication de verre noirci de blindage contre les interférences électromagnétiques selon la revendication 1, dans lequel le verre sur lequel le composant d'étain est diffusé est produit en utilisant un procédé float.

3. Procédé de fabrication de verre noirci de blindage contre les interférences électromagnétiques selon la revendication 1, dans lequel la pâte conductrice est préparée en dispersant des poudres métalliques, un liant polymère, et une fritte de verre dans un solvant organique.

4. Procédé de fabrication de verre noirci de blindage contre les interférences électromagnétiques selon la revendication 3, dans lequel la pâte conductrice comporte de 70 à 90 % en poids de poudre métallique, de 0,1 à 15 % en poids de fritte de verre, et de 5 à 30 % en poids de solution de résine de liant organique qui comporte le liant polymère et le solvant organique, et la quantité du liant polymère dans la solution de résine de liant organique est de l'ordre de 20 à 80 % en poids de la somme totale des poids du solvant organique et du liant polymère.

5. Procédé de fabrication de verre noirci de blindage contre les interférences électromagnétiques selon la revendication 3, dans lequel la fritte de verre comporte une fritte de verre de couleur.

6. Procédé de fabrication de verre noirci de blindage contre les interférences électromagnétiques selon l'une quelconque des revendications 1 à 5, dans lequel le réseau conducteur est formé en utilisant le procédé d'impression.

7. Procédé de fabrication de verre noirci de blindage contre les interférences électromagnétiques selon l'une quelconque des revendications 1 à 5, dans lequel le verre est cuit à la température se trouvant dans la plage allant de 400 à 700°C.

8. Verre noirci de blindage contre les interférences électromagnétiques comportant : un verre et un réseau conducteur qui est formé sur une surface du verre, **caractérisé en ce que**, un composant d'étain est diffusé sur ladite surface du verre et une interface entre le réseau conducteur et le verre est noircie par cuisson du verre sur lequel le réseau conducteur est formé.

9. Verre noirci de blindage contre les interférences électromagnétiques selon la revendication 8, dans lequel le réseau conducteur est formé en utilisant la pâte conductrice qui est préparée en dispersant des poudres métalliques, un liant polymère, et une fritte de verre dans un solvant organique.

10. Verre noirci de blindage contre les interférences électromagnétiques selon la revendication 9, dans lequel la pâte conductrice comporte de 70 à 90 % en poids de poudre métallique, de 0,1 à 15 % en poids de fritte de verre, et de 5 à 30 % en poids de solution de résine de liant organique qui comporte le liant polymère et le solvant organique, et la quantité du liant polymère dans la solution de résine de liant organique est de l'ordre de 20 à 80 % en poids de la somme totale des poids du solvant organique et du liant polymère.

11. Verre noirci de blindage contre les interférences électromagnétiques selon la revendication 9, dans lequel la fritte de verre comporte une fritte de verre de couleur.

12. Verre noirci de blindage contre les interférences électromagnétiques selon la revendication 8, dans lequel le réseau conducteur est formé en utilisant le procédé d'impression sur la surface du verre sur lequel le composant d'étain est diffusé.

13. Verre noirci de blindage contre les interférences électromagnétiques selon la revendication 8, dans lequel la couche noircie est formée en cuisant le verre sur lequel le réseau conducteur est formé à une température se trouvant dans la plage allant de 400 à 700°C.

14. Filtre d'écran à plasma comportant :
un verre noirci de blindage contre les interférences électromagnétiques selon l'une quelconque des revendications 8 à 13 ; et
au moins un film qui est attaché sur un côté avant ou un côté arrière du verre noirci de blindage contre les interférences électromagnétiques et est sélectionné dans le groupe constitué par un film antireflet, un film de blindage contre les rayons infrarouges proches, et un film correcteur de couleur.

15. Dispositif d'écran à plasma comportant le filtre d'écran à plasma selon la revendication 14.
